# EUROPEAN PATENT APPLICATION

(11) **EP 4 131 450 A1**
(43) Date of publication of application: **08.02.2023**
(21) Application number: 20750162.8
(22) Date of filing: 10.04.2020
(51) Int. Cl.: H01L 51/52

(54) **DISPLAY PANEL AND DISPLAY DEVICE**

(30) Priority: 27.03.2020 CN 202010227725
(71) Applicant: Wuhan China Star Optoelectronics Semiconductor Display Technology Co., Ltd., Wuhan, Hubei 430079 (CN)
(72) Inventor: ZHU, Cuilin, Wuhan, Hubel 430079 (CN)
(74) Representative: Murgitroyd & Company
(86) International application number: PCT/CN2020/084084
(87) International publication number: WO 2021/189542

(57) **Abstract**

A display panel and a display device are provided. The display device in an embodiment of the present disclosure includes a pixel array and a flexible substrate. The flexible substrate includes a first area and a second area disposed on a bottom of the pixel array, and a bending area disposed between the first area and the second area; wherein, the flexible substrate in the bending area is completely or partially hollowed out along a bending direction.

## Description

### FIELD OF INVENTION

The present disclosure relates to the field of display technologies, and more particularly, to a display panel and a display device.

### BACKGROUND OF INVENTION

In modern communication industry, market demand for mobile phones, TVs, tablets, notebooks, digital cameras, and other products is increasing, and various display devices are also developing toward curved displays and multi-surface displays.

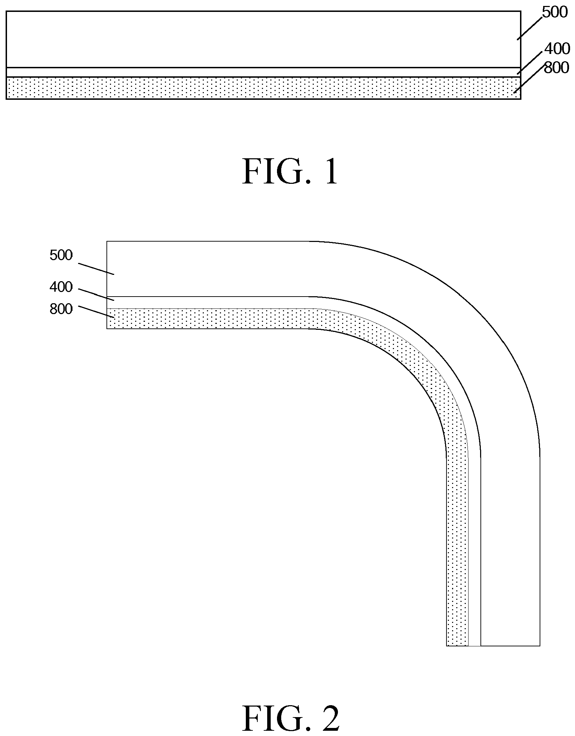

During production of flexible display panels, a cover glass (CG) bonding technique is used. Conventional bonding technique is developing toward a curved surface bonding technique. However, as shown in FIGs. 1 and 2, during a curved surface bonding process, current display panels have thicker stacked layers including a flexible substrate 800, an adhesive layer 400, and a pixel array 500 at corner positions thereof, so bonding deformation among the stacked layers at a bending part causes stress concentration, which easily leads to breaking or peeling off of the stacked layers of the display panels broken or peel off, thereby causing the display panels to display poorly.

Technical problem: an embodiment of the present disclosure provides a display panel and a display device. It aims to solve a problem of stress concentration caused by bonding deformation among stacked layers during bending of the display panel, which easily leads to breaking or peeling off of the stacked layers of the display panel, thereby causing the display panel to display poorly.

### SUMMARY OF INVENTION

An embodiment of the present disclosure provides a display panel which comprises:
a pixel array;
a flexible substrate including a first area and a second area disposed on a bottom of the pixel array, and a bending area disposed between the first area and the second area,
wherein the flexible substrate in the bending area is completely or partially hollowed out along a bending direction; and
an adhesive layer disposed between the flexible substrate and the pixel array, wherein an area of the adhesive layer corresponding to the bending area is completely or partially hollowed out along the bending direction;
wherein hollowed-out areas are filled with a protective layer.

In some embodiments of the present disclosure, a thickness of the protective layer is not greater than a depth of the hollowed-out areas.

An embodiment of the present disclosure further provides a display panel which comprises:
a pixel array including a thin film transistor layer, an anode, an OLED light-emitting layer, and a cathode stacked in sequence from top to bottom; and
a flexible substrate including a first area and a second area disposed on a bottom of the pixel array, and a bending area disposed between the first area and the second area; wherein the flexible substrate may use a polyethylene terephthalate (PET) material; and
wherein, the flexible substrate in the bending area is completely or partially hollowed out along a bending direction.

In some embodiments of the present disclosure, the display panel further comprises an adhesive layer disposed between the flexible substrate and the pixel array. The adhesive layer can be an optically clear adhesive (OCA), and the adhesive layer corresponding to the bending area is completely or partially hollowed out along a radial direction.

In some embodiments of the present disclosure, the above display panel further comprises a protective layer filled in the hollowed-out areas.

In some embodiments of the present disclosure, a thickness of the protective layer in the display panel is not greater than a depth of the hollowed-out areas.

In some embodiments of the present disclosure, the protective layer is an ultra-violet (UV) sensitive adhesive.

In some embodiments of the present disclosure, a cross-sectional shape of hollowed-out areas is one or more of trapezoidal, semi-circular, or rectangular.

In some embodiments of the present disclosure, a number of hollowed-out areas is one.

In some embodiments of the present disclosure, the number of hollowed-out areas is plural and the hollowed-out areas are arranged in a discontinuous manner.

In some embodiments of the present disclosure, a width of a cross-section of the hollowed-out areas is not greater than a width of the bending area.

An embodiment of the present disclosure further provides a display device which comprises a display panel. The display panel comprises:
a pixel array;
a flexible substrate including a first area and a second area disposed on a bottom of the pixel array, and a bending area disposed between the first area and the second area;
wherein the flexible substrate in the bending area is completely or partially hollowed out along a bending direction.

In some embodiments of the present disclosure, the display panel further comprises an adhesive layer disposed between the flexible substrate and the pixel array, wherein an area of the adhesive layer corresponding to the bending area is completely or partially hollowed out along the bending direction.

In some embodiments of the present disclosure, hollowed-out areas are filled with a protective layer.

In some embodiments of the present disclosure, a thickness of the protective layer is not greater than a depth of the hollowed-out areas.

In some embodiments of the present disclosure, the protective layer is an ultra-violet (UV) sensitive adhesive.

In some embodiments of the present disclosure, a cross-sectional shape of the hollowed-out areas is one or more of trapezoidal, semi-circular, or rectangular.

In some embodiments of the present disclosure, a number of the hollowed-out areas is one.

In some embodiments of the present disclosure, the number of the hollowed-out areas is plural and the hollowed-out areas are arranged in a discontinuous manner.

In some embodiments of the present disclosure, a width of a cross-section of the hollowed-out areas is not greater than a width of the bending area.

Beneficial effect: the display panel and the display device provided by the embodiments of the present disclosure, through forming hollowed-out areas in a portion of a flexible substrate corresponding to a bending area, reduce a total thickness of the finished display panel in the bending area, which prevents fractures or peeling caused by stress concentration which is caused by bonding deformation among stacked layers during bending of the finished display panel, thereby solving a problem of the display panel displaying poorly caused by the fractures of the stacked layers in the display panel or the peeling among the stacked layers. The flexible substrate in the bending area mainly plays a role in protection. In the technical solution of the present disclosure, hollowing out the flexible substrate in the bending area has no influence on display effect.

In a preferred embodiment of the present disclosure, an adhesive layer corresponding to the bending area is completely or partially hollowed out along a bending direction, which further reduces the total thickness of the finished display panel in the bending area to prevent the stress concentration, thereby solving the problem of poor display in the bending area of the flexible display panel. The adhesive layer mainly plays a role in bonding the flexible substrate and the pixel array. In the case where the flexible substrate in the area has been hollowed out, further hollowing out the adhesive layer in the area will not have negative influence on the display effect, nor will it have negative influence on adhesion between layers.

For a problem caused by lack of protection after hollowing out the flexible substrate, an embodiment of the present disclosure can protect the product from external damage by disposing a protective layer filled in the hollowed-out areas to have an isolation effect. A thickness of the protective layer in the embodiment is not greater than a depth of the hollowed-out areas, so the total thickness of the finished display panel in the bending area is reduced. A UV sensitive adhesive used in the protective layer in the embodiments of the present disclosure, due to characteristics of the material, when bending the display panel, generates a bending stress less than bending stresses generated by the flexible substrate and the adhesive layer, thereby preventing the problem of the display panel displaying poorly caused by the fractures of the stacked layers in the display panel or the peeling among the stacked layers. A width of a cross-section of the hollowed-out areas is not greater than a width of the bending area, which allows performance of non-bending areas of the display panel to not be affected.

### DESCRIPTION OF DRAWINGS

The accompanying figures to be used in the description of embodiments of the present disclosure will be described in brief to more clearly illustrate the technical solutions of the embodiments. The accompanying figures described below are only part of the embodiments of the present disclosure, from which those skilled in the art can derive further figures without making any inventive efforts.
FIG. 1 is a partial schematic structural diagram of a display panel in a non-bending state in current technology.
FIG. 2 is a partial schematic structural diagram of a display panel in a bending state in current technology.
FIG. 3 is a schematic structural diagram of a display panel according to an embodiment of the present disclosure.
FIG. 4 is another schematic structural diagram of a display panel according to an embodiment of the present disclosure.
FIG. 5 is yet another schematic structural diagram of a display panel according to an embodiment of the present disclosure.

Elements in the drawings are designated by reference numerals listed below.
100. first area; 200. bending area; 300. second area; 400. adhesive layer; 500. pixel array; 600. groove; 700. protective layer; 800. flexible substrate.

### DETAILED DESCRIPTION OF PREFERRED EMBODIMENTS

The technical solutions in the embodiments of the present disclosure will be clearly and completely described below with reference to the drawings in the embodiments of the present disclosure. Obviously, the described embodiments are only a part of the embodiments of the present disclosure, but not all the embodiments. Based on the embodiments in the present disclosure, all other embodiments obtained by those skilled in the art without creative efforts are within the scope of the present disclosure.

In the description of the present disclosure, it should be understood that terms such as "center", "longitudinal", "lateral", "length", "width", "thickness", "upper", "lower", "front", "rear", "left", "right", "vertical", "horizontal", "top", "bottom", "inside", "outside", as well as derivative thereof should be construed to refer to the orientation as described or as shown in the drawings under discussion. These relative terms are for convenience of description, do not require that the present disclosure be constructed or operated in a particular orientation, and shall not be construed as causing limitations to the present disclosure. In addition, terms such as "first" and "second" are used herein for purposes of description and are not intended to indicate or imply relative importance or implicitly indicating the number of technical features indicated. Thus, features limited by "first" and "second" are intended to indicate or imply including one or more than one these features. In the description of the present disclosure, "a plurality of" relates to two or more than two, unless otherwise specified.

In production of current flexible display panels, during a curved surface bonding process, current display panels have thicker stacked layers including a flexible substrate, an optically clear adhesive (OCA), and a pixel array at corner positions thereof, so bonding deformation among the stacked layers causes stress concentration, which easily leads to breaking or peeling off of the stacked layers of the display panels, thereby causing the display panels to display poorly. An embodiment of the present disclosure provides a display panel and a display device to solve the above problems.

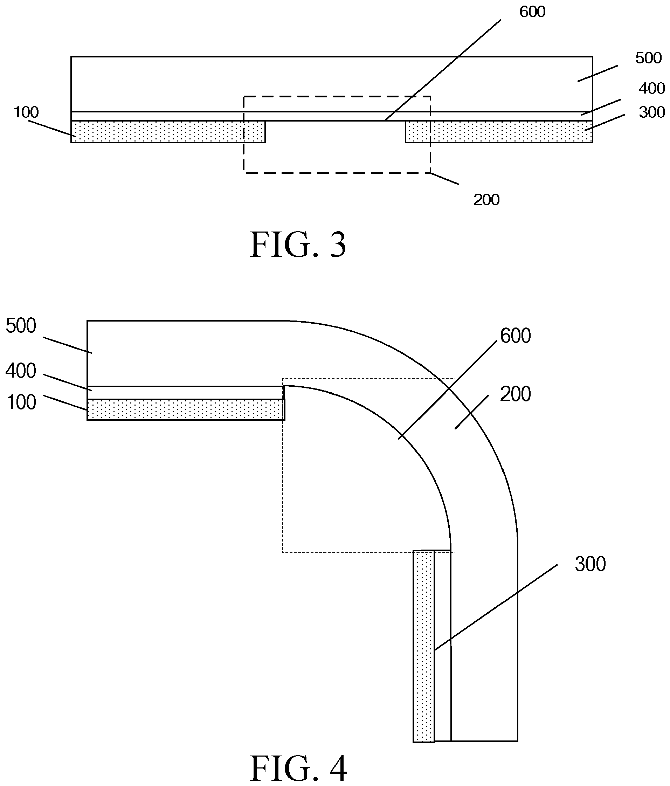

As shown in FIG. 3, FIG. 3 is a schematic structural diagram of a first display panel in an embodiment of the present disclosure. Wherein, the display panel comprises a pixel array 500 and a flexible substrate 800.

Wherein, the pixel array 500 includes a thin film transistor layer, an anode, an OLED light-emitting layer, and a cathode (which are not shown in the figure) stacked in sequence from top to bottom.

The flexible substrate 800 includes a first area 100 and a second area 300 disposed on a bottom of the pixel array 500, and a bending area 200 disposed between the first area 100 and the second area 300.

Specifically, a material of the flexible substrate is polyethylene terephthalate (PET) or polyimide.

Wherein, in the bending area, the flexible substrate 800 in the bending area is completely or partially hollowed out along a radial direction. The hollowed-out part forms a groove 600.

Specifically, there may be setting of one groove 600 or a plurality of grooves 600 arranged in a discontinuous manner. In the embodiment, a number of the groove 600 is one.

Specifically, a cross-sectional shape of the groove 600 is one of trapezoidal, semi-circular, or rectangular, and may be other shape. It should be noted that the cross-sectional shape of the groove 600 is a shape of the flexible substrate 800 in a non-bending state. The cross-sectional shape of the groove 600 in the embodiment is rectangular.

Specifically, a bending angle of the bending area 200 is 90°.

Specifically, a width of a cross-section of the groove 600 is not greater than a width of the bending area 200. In a preferred embodiment, the width of the cross-section of the groove 600 is equal to the width of the bending area 200, and at this time, the bonding deformation among the stacked layers in the bending area 200 is minimal.

Specifically, a thin film encapsulation layer, a touch control layer, a polarizer, and a protective cover (which are not shown in the figure) are disposed in a stack on the pixel array 500. In a preferred embodiment, a backboard and a layer of copper, graphite, and foam (which are not shown in the figure) are disposed on one side of the flexible substrate 800 facing away from the pixel array 500.

The display panel provided by the embodiments of the present disclosure has a plurality of uses, for example, it can be used on wearable devices such as smart wristbands, smart watches, virtual reality (VR), etc. It can also be used on flexible OLED displays such as mobile phones, e-books and e-newspapers, TVs, personal laptops, and foldable and rollable OLEDs, and lighting devices. After the display panel of the embodiment is applied, it can withstand a greater bending angle and improve yield of devices.

The embodiment of the present disclosure provides a display panel and a display device. Through forming hollowed-out areas in a portion of the flexible substrate 800 corresponding to the bending area 200, the present disclosure reduces a total thickness of the finished display panel in the bending area 200, which prevents fractures or peeling caused by stress concentration which is caused by bonding deformation among stacked layers during bending of the finished display panel, thereby solving the problem of the display panel displaying poorly caused by the fractures of the stacked layers in the display panel or the peeling among the stacked layers. The flexible substrate 800 in the bending area 200 mainly plays a role in protection. In the technical solution of the present disclosure, hollowing out the flexible substrate 800 in the bending area 200 has no influence on display effect.

As shown in FIG. 4, based on the above embodiment, in another specific embodiment of the present disclosure, the display panel further comprises an adhesive layer 400 disposed between the flexible substrate 800 and the pixel array 500. The adhesive layer 400 can be an optically clear adhesive (OCA), and the adhesive layer 400 corresponding to the bending area 200 is completely or partially hollowed out along the radial direction. The hollowed-out part forms a groove 600.

In the embodiment, the adhesive layer 400 plays a role in bonding the pixel array 500 and the flexible substrate 800.

In a preferred embodiment, the adhesive layer 400 is the OCA.

The embodiment of the present disclosure provides a display panel and a display device. Through completely or partially hollowing out the adhesive layer 400 corresponding to the bending area 200 along a bending direction, the embodiment of the present disclosure further reduces the total thickness of the finished display panel in the bending area, which prevents the stress concentration, thereby solving the problem of poor display in the bending area of the flexible display panel. The adhesive layer 400 mainly plays a role in bonding the flexible substrate 800 and the pixel array 500. In the case where the flexible substrate 800 in the bending area has been hollowed out, further hollowing out the adhesive layer 400 in the bending area will have no negative influence on the display effect, nor will it have negative influence on adhesion between layers.

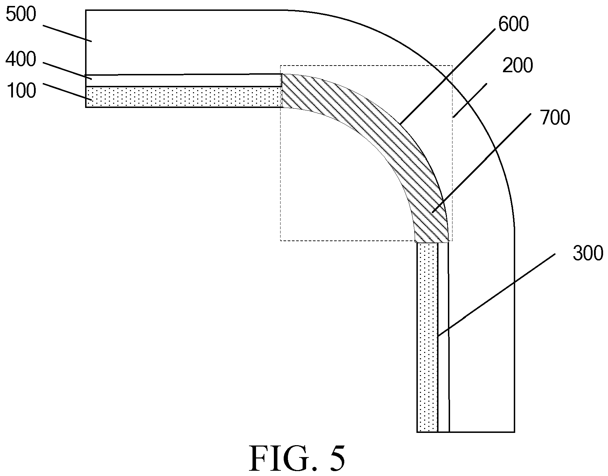

As shown in FIG. 5, based on the above embodiments, in yet another specific embodiment of the present disclosure, the groove 600 is filled with a protective layer 700.

In a preferred embodiment of the present disclosure, a thickness of the protective layer 700 is not greater than a depth of the groove 600.

In a preferred embodiment of the present disclosure, the protective layer 700 is an ultra-violet (UV) sensitive adhesive.

Specifically, there may be setting of one groove 600 or a plurality of grooves 600 arranged in a discontinuous manner. In the embodiment, a number of the groove 600 is one.

Specifically, a cross-sectional shape of the groove 600 is one or more of trapezoidal, semi-circular, or rectangular, and may be other shape. It should be noted that the cross-sectional shape of the groove 600 is a shape of the flexible substrate 800 in a non-bending state. The cross-sectional shape of the groove 600 in the embodiment is rectangular.

Specifically, a width of a cross-section of the groove 600 is not greater than a width of the bending area 200. In a preferred embodiment, the width of the cross-section of the groove 600 is equal to the width of the bending area 200, and at this time, the bonding deformation among the stacked layers in the bending area 200 is minimal.

Specifically, a thin film encapsulation layer, a touch control layer, a polarizer, and a protective cover (which are not shown in the figure) are disposed in a stack on the pixel array 500. In a preferred embodiment, a backboard and a layer of copper, graphite, and foam (which are not shown in the figure) are disposed on one side of the flexible substrate 800 facing away from the pixel array 500.

The display panel provided by the embodiments of the present disclosure has a plurality of uses, for example, it can be used on wearable devices such as smart wristbands, smart watches, virtual reality (VR), etc. It can also be used on flexible OLED displays such as mobile phones, e-books and e-newspapers, TVs, personal laptops, and foldable and rollable OLEDs, and lighting devices. After the display panel of the embodiment is applied, it can withstand a greater bending angle and improve yield of devices.

The embodiment of the present disclosure provides a display panel and a display device. For a problem caused by lack of protection after hollowing out the flexible substrate 800, the embodiment of the present disclosure can protect the product from external damage by disposing the protective layer 700 filled in the hollowed-out areas to have an isolation effect. A thickness of the protective layer 700 in the embodiment is not greater than a depth of the hollowed-out areas, so the total thickness of the finished display panel in the bending area 200 is reduced. A UV sensitive adhesive used in the protective layer 700 in the embodiments of the present disclosure, due to characteristics of the material, when bending the display panel, generates a stress less than stresses generated by the flexible substrate 800 and the adhesive layer 400, thereby preventing the problem of the display panel displaying poorly caused by the fractures of the stacked layers in the display panel or the peeling among the stacked layers. A width of a cross-section of the hollowed-out areas is not greater than a width of the bending area 200, which allows performance of non-bending areas of the display panel to not be affected.

An embodiment of the present disclosure further provides a display device, which comprises any one of the display panels in the above embodiments.

It should be noted that only above structures are described in the above embodiments of the display panel, but it can be understood that in addition to the above structures, the display panel in the embodiment of the present disclosure also can comprise other necessary structures according to requirements, which is not specifically limited herein.

The display panel and the display device provided by the embodiments of the present disclosure are described in detail above. Specific examples are used herein to explain the principles and implementation of the present disclosure. The descriptions of the above embodiments are only used to help understand the method of the present disclosure and its core ideas; meanwhile, for those skilled in the art, the range of specific implementation and application may be changed according to the ideas of the present disclosure. In summary, the content of the specification should not be construed as causing limitations to the present disclosure.

## Claims

1. A display panel, comprising:
a pixel array;
a flexible substrate including a first area and a second area disposed on a bottom of the pixel array, and a bending area disposed between the first area and the second area, wherein the flexible substrate in the bending area is completely or partially hollowed out along a bending direction; and
an adhesive layer disposed between the flexible substrate and the pixel array, wherein an area of the adhesive layer corresponding to the bending area is completely or partially hollowed out along the bending direction;
wherein hollowed-out areas are filled with a protective layer.

2. The display panel according to claim 1, wherein a thickness of the protective layer is not greater than a depth of the hollowed-out areas.

3. A display panel, comprising:
a pixel array; and
a flexible substrate including a first area and a second area disposed on a bottom of the pixel array, and a bending area disposed between the first area and the second area, wherein the flexible substrate in the bending area is completely or partially hollowed out along a bending direction.

4. The display panel according to claim 3, further comprising an adhesive layer disposed between the flexible substrate and the pixel array, wherein an area of the adhesive layer corresponding to the bending area is completely or partially hollowed out along the bending direction.

5. The display panel according to claim 3, wherein hollowed-out areas are filled with a protective layer.

6. The display panel according to claim 5, wherein a thickness of the protective layer is not greater than a depth of the hollowed-out areas.

7. The display panel according to claim 5, wherein the protective layer is an ultra-violet (UV) sensitive adhesive.

8. The display panel according to claim 3, wherein a cross-sectional shape of hollowed-out areas is one or more of trapezoidal, semi-circular, or rectangular.

9. The display panel according to claim 3, wherein a number of hollowed-out areas is one.

10. The display panel according to claim 3, wherein a number of hollowed-out areas is plural and the hollowed-out areas are arranged in a discontinuous manner.

11. The display panel according to claim 3, wherein a width of a cross-section of hollowed-out areas is not greater than a width of the bending area.

12. A display device, comprising a display panel, wherein the display panel comprises:
a pixel array;
a flexible substrate including a first area and a second area disposed on a bottom of the pixel array, and a bending area disposed between the first area and the second area;
wherein the flexible substrate in the bending area is completely or partially hollowed out along a bending direction.

13. The display device according to claim 12, further comprising an adhesive layer disposed between the flexible substrate and the pixel array, wherein an area of the adhesive layer corresponding to the bending area is completely or partially hollowed out along the bending direction.

14. The display device according to claim 12, wherein hollowed-out areas are filled with a protective layer.

15. The display device according to claim 14, wherein a thickness of the protective layer is not greater than a depth of the hollowed-out areas.

16. The display device according to claim 14, wherein the protective layer is an ultra-violet (UV) sensitive adhesive.

17. The display device according to claim 12, wherein a cross-sectional shape of hollowed-out areas is one or more of trapezoidal, semi-circular, or rectangular.

18. The display device according to claim 12, wherein a number of hollowed-out areas is one.

19. The display device according to claim 12, wherein a number of hollowed-out areas is plural and the hollowed-out areas are arranged in a discontinuous manner.

20. The display device according to claim 12, wherein a width of a cross-section of hollowed-out areas is not greater than a width of the bending area.
